# FASCICULE DE BREVET EUROPEEN

(11) **EP 3 902 382 B1**
(45) Date de publication et mention de la délivrance du brevet: **14.06.2023**
(21) Numéro de dépôt: 21168967.4
(22) Date de dépôt: 16.04.2021
(51) Int. Cl.: H05K 7/14, H05K 7/20

(54) **ENSEMBLE ÉLECTRIQUE COMPRENANT UN MODULE DE PUISSANCE ET UN MODULE CAPACITIF, AINSI QU'UN ORGANE D'INDEXATION**
ELEKTRISCHE BAUGRUPPE MIT EINEM LEISTUNGSMODUL UND EINEM KAPAZITIVEN MODUL SOWIE EINEM INDEXIERUNGSELEMENT
ELECTRICAL ASSEMBLY COMPRISING A POWER MODULE AND A CAPACITIVE MODULE, AS WELL AS AN INDEXING MEMBER

(30) Priorité: 21.04.2020 FR 2003961
(43) Date de publication de la demande: 27.10.2021
(73) Titulaire: Valeo eAutomotive France SAS, 95800 Cergy (FR)
(72) Inventeur: LEGENDRE, Alexandre, 95800 Cergy (FR); POUILLY, Aurélien, 95800 Cergy (FR)
(74) Mandataire: Valeo Powertrain Systems

(56) Documents cités:
- EP-A2- 2 367 277
- FR-A1- 3 076 063
- JP-A- 2004 266 973
- US-A1- 2012 206 950

## Description

### DOMAINE TECHNIQUE

La présente invention concerne le domaine des équipements électriques, notamment des onduleurs, pour véhicules électriques ou hybrides.

Plus précisément, la présente invention concerne un ensemble électrique comprenant un support, sur lequel sont assemblés des composants électriques et mécaniques, notamment une capacité de liaison, un module de puissance et un module de refroidissement, ledit ensemble électrique étant destiné à être installé dans un châssis pour former un équipement électrique, notamment un onduleur, ledit ensemble comprenant par ailleurs un organe d'indexation pour permettre un positionnement optimisé de la capacité de liaison vis-à-vis du module de puissance.

Ledit support peut par exemple, mais non nécessairement, être un couvercle de l'équipement électrique.

### ETAT DE LA TECHNIQUE

Il est connu des équipements électriques, notamment des onduleurs ou des convertisseurs de puissance, comprenant des cartes électroniques, des composants électriques tels que des bobines et des éléments mécaniques connectés ou fixés et logés dans un châssis ou un boîtier, notamment fermé par un couvercle.

De tels équipements électriques sont notamment mis en oeuvre dans le domaine des véhicules automobiles. En particulier, dans des véhicules électriques ou hybrides, on utilise, pour réaliser un système de motorisation électrique, de tels équipements électriques aptes à fonctionner sous des tensions supérieures à 100 V.

En particulier dans le domaine de la construction de véhicules automobiles, notamment électriques ou hybrides, il peut être requis, à des fins de compatibilités avec des processus d'assemblage spécifiques, de disposer d'ensembles électriques dépourvus de châssis ou de boîtier.

Il est alors rendu nécessaire de concevoir un ensemble électrique dont les composants électriques et mécaniques, les cartes électroniques éventuellement, tiennent ensemble, formant un ensemble solidaire, sans que ledit ensemble ne puisse, à un certain stade du processus d'assemblage, s'appuyer sur la référence mécanique que constitue normalement le châssis pour être maintenu. Les documents EP2367277, JP2004266973, US2012206950 et FR3076063 connus de l'art antérieur décrivent de tels ensembles électriques.

Dans ce contexte, on s'intéresse au positionnement de la capacité de liaison vis-à-vis du module de puissance. Plus exactement, ce qui importe ici concerne le positionnement de la barre de connexion électrique, en fait des bornes de connexion, de la capacité de liaison par rapport à celles du module de puissance.

Le problème technique afférent au positionnement de la capacité de liaison vis-à-vis du module de puissance est lié à la notion de chaîne de cotes : en cas de non centrage des bornes de connexion de la capacité de liaison par rapport à celles du module de puissance, il existe en effet un risque élevé de non montabilité de la capacité de liaison sur le module de puissance.

Le problème à résoudre réside ainsi dans le centrage de la capacité de liaison sur le module de puissance, de sorte à ce que leurs bornes respectives soient centrées les unes par rapport aux autres, sans s'appuyer sur des éléments de centrage intégrées au châssis de l'équipement électrique considéré. L'objectif est également de ne pas sur-contraindre le module de puissance sur le plan mécanique.

### PRESENTATION DE L'INVENTION

Plus précisément, l'invention a pour objet un ensemble électrique pour un équipement électrique, notamment un onduleur, comprenant :
- un support comprenant un module de refroidissement configuré pour dissiper de la chaleur émise par une capacité ;
- une capacité, configurée pour filtrer un signal électrique continu, comprenant au moins une bobine capacitive et au moins une barre de connexion électrique fixée à ladite au moins une bobine capacitive, ladite au moins une barre de connexion électrique ayant des bornes de connexion ;
- un module de puissance ayant des bornes de connexion ;
- un élément séparateur disposé entre la capacité de liaison et le module de refroidissement, l'élément séparateur comprend,
- un organe d'indexation configuré pour s'indexer directement, respectivement, sur les bornes de connexion de la capacité et les bornes de connexion du module de puissance,
de sorte à assurer le centrage des bornes de connexion de la capacité directement vis-à-vis des bornes de connexion du module de puissance dans lequel l'organe d'indexation est formé de parois de centrage issues de matière de l'élément séparateur.

Avantageusement, l'élément séparateur disposé entre le module de refroidissement et la capacité de liaison et adapté pour recevoir un coussin de dissipation thermique, ledit élément séparateur étant configuré pour limiter le taux de compression du coussin de dissipation thermique de sorte à garantir une épaisseur minimale prédéfinie dudit coussin de dissipation thermique.

Avantageusement, l'organe d'indexation de l'élément séparateur forme un peigne adapté pour s'indexer sur les bornes de connexion électrique du module de puissance.

Avantageusement, l'organe d'indexation est un ensemble de nervures, en particulier formant des parois de centrage.

Selon un mode de réalisation, l'organe d'indexation comprend des parois de guidage espacées formant un passage pour recevoir une portion des bornes de connexion du module de puissance et, respectivement, des bornes de connexion de la capacité.

Selon un mode de réalisation, l'organe d'indexation comprend, entre chaque paire de parois de guidage, une poutre orthogonale auxdites parois de guidage pour les relier entre elles de façon à rigidifier l'organe d'indexation et pour éviter que lesdites parois de guidage ne se rapprochent l'une de l'autre.

Selon un mode de réalisation, ledit ensemble électrique comporte un module de refroidissement configuré pour être prise en sandwich entre ladite capacité et ledit module de puissance.

Selon une forme de réalisation, la capacité est une capacité de liaison configurée pour filtrer un signal électrique continu.

L'invention voise également un procédé d'assemblage d'un ensemble électrique tel que brièvement décrit ci-dessus, dans lequel on dispose le module de refroidissement, puis on dispose le module de puissance, puis on dispose l'élément séparateur comprenant l'organe d'indexation sur le module de refroidissement, de telle sorte que l'organe d'indexation s'indexe sur les bornes de connexion du module de puissance, puis on dispose la capacité sur l'élément séparateur, de telle sorte que les bornes de connexion de la capacité de liaison s'indexent sur l'organe d'indexation en étant guidées par ce dernier.

La présente invention vise aussi un équipement électrique comprenant un châssis, formant un boîtier avec un fond et des parois latérales, et un ensemble électrique tel que brièvement décrit précédemment, ledit ensemble électrique étant inséré à l'intérieur dudit châssis.

Notamment, ledit ensemble électrique est fixé à un élément solidaire dudit châssis.

Par exemple, ledit support est un couvercle de l'équipement électrique.

Avantageusement, ledit équipement électrique forme un onduleur électrique, notamment pour un véhicule automobile.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
[Fig. 1] : la figure 1 est une représentation schématique d'un exemple d'ensemble électrique selon l'invention ;
[Fig. 2] : la figure 2 est une représentation schématique de la capacité de liaison notamment prévue dans l'ensemble électrique de la figure 1 ;
[Fig. 3] : la figure 3 est une représentation schématique du module de puissance notamment prévu dans l'ensemble électrique de la figure 1 ;
[Fig. 4] : la figure 4 est une représentation schématique de l'élément séparateur, comprenant un organe d'indexation, selon un exemple de réalisation de l'invention ;
[Fig. 5] : la figure 5 est une représentation schématique d'un ensemble électrique avec un module de refroidissement.

Il faut noter que les figures exposent l'invention de manière détaillée pour permettre de mettre en oeuvre l'invention, lesdites figures pouvant bien entendu servir à mieux définir l'invention le cas échéant.

### DESCRIPTION DETAILLEE DE L'INVENTION

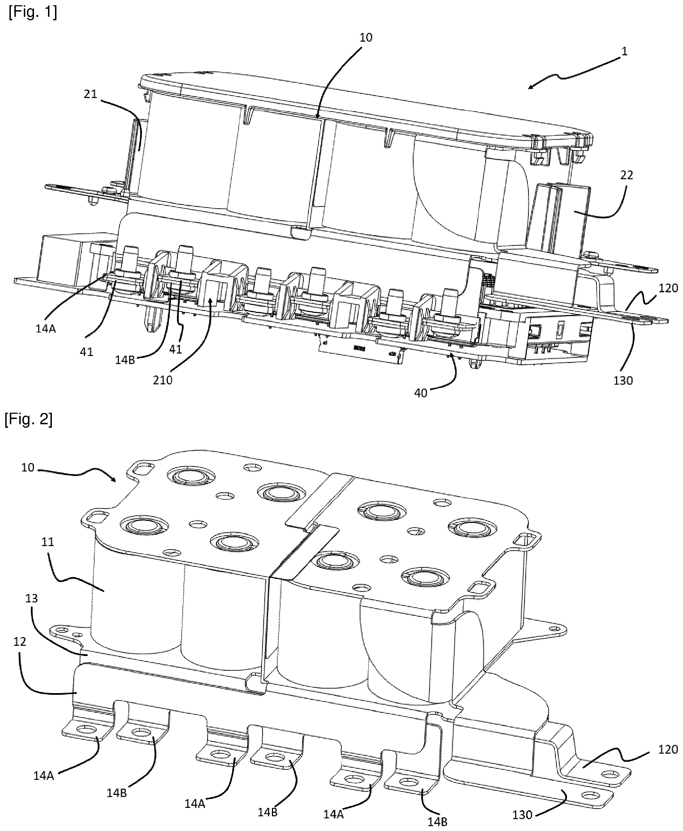

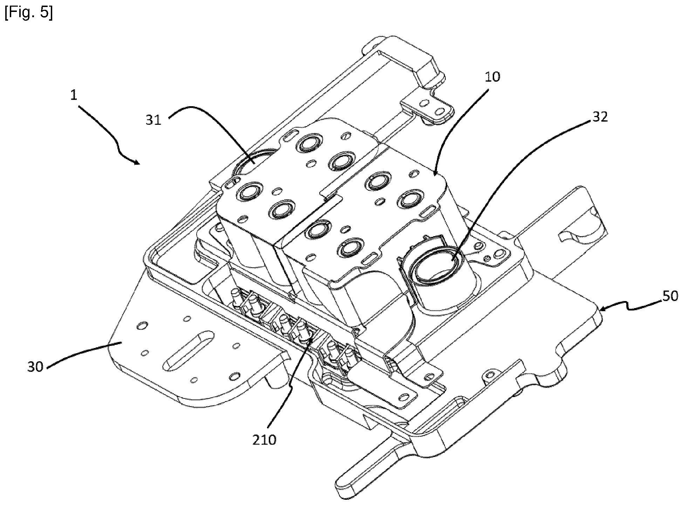

Comme représenté sur la figure 1 et la figure 5, qui montrent un exemple de réalisation, la présente invention concerne un ensemble électrique 1.

Le mode de réalisation de la figure 1 et de la figure 5 représente un ensemble électrique 1 comprenant notamment une capacité 10 dotée d'une première barre de connexion électrique 12 correspondant à une borne de connexion électrique 120 de charge positive et d'une deuxième barre de connexion électrique 13 correspondant à une borne de connexion électrique 130 de charge négative.

Il faut noter que dans l'exemple décrit ci-après, la capacité 10 est une capacité de liaison. Toutefois, cet exemple est illustratif et non restrictif et la capacité 10 peut aussi bien être une capacité de type différent, comprenant au moins une bobine capacitive. Comme cela est connu, la capacité de liaison 10 est un composant électrique de filtrage configuré d'une part pour atténuer des perturbations des signaux de courant transférés via l'équipement électrique considéré et d'autre part pour constituer une réserve de courant destiné à alimenter des composants dudit équipement électrique.

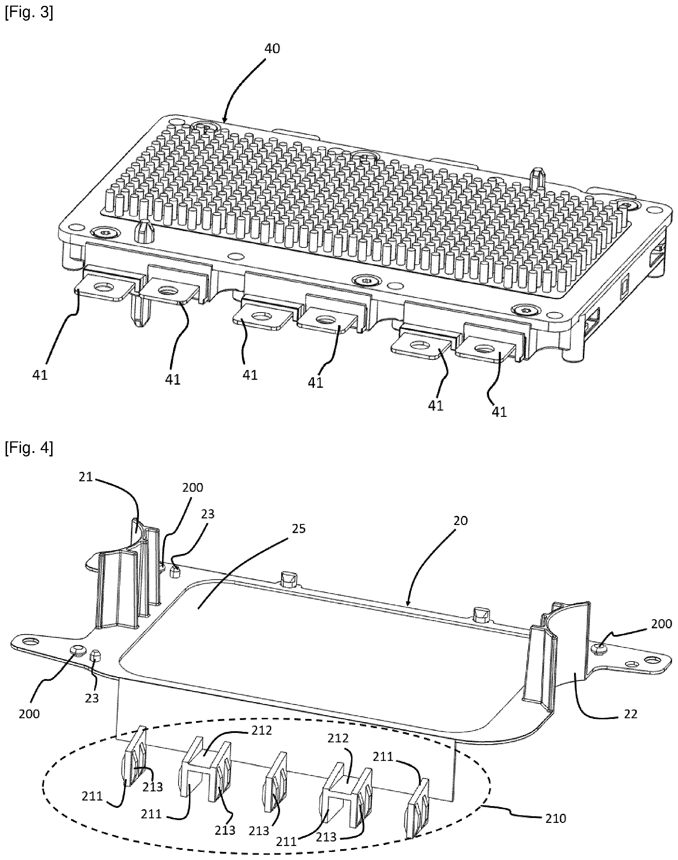

L'ensemble électrique 1 comprend en outre un élément séparateur 20 recevant un coussin de dissipation thermique 25 (visible sur la figure 4) disposé entre ladite capacité de liaison 10 et un module de refroidissement 30.

Ce module de refroidissement 30 est notamment fixé, par l'intermédiaire de vis à un support 50, notamment un couvercle ; il peut alternativement faire partie intégrante dudit support 50. Le module de refroidissement 30 est par exemple en aluminium. Le support 50 et le module de refroidissement 30 forment, ensemble, un support 50 pour l'ensemble électrique selon l'invention.

Le module de refroidissement 30, avec le support 50 auquel il est fixé ou intégré, forme un support 50 sur lequel sont assemblés l'élément séparateur 20 recevant le coussin de dissipation thermique 25 et la capacité de liaison 10.

Dans un processus d'assemblage d'un équipement électrique, on constitue par conséquent d'abord l'ensemble électrique 1, tel que celui représenté sur la figure 1. Sur un support 50, on assemble dans cet ordre l'élément séparateur 20 recevant le coussin de dissipation thermique 25 et la capacité de liaison 10. Bien entendu, d'autres composants électriques ou mécaniques et/ou une ou plusieurs cartes électroniques peuvent être fixés à un moment choisi sur l'un des éléments précités de l'ensemble électrique 1. Le support est par exemple un couvercle qui intègre le module de refroidissement 30. Alternativement, ledit module de refroidissement 30 est fixé audit support, par exemple par l'intermédiaire de vis ou de clips ou de tout autre moyen équivalent.

Comme cela est visible sur la figure 2, la capacité de liaison 10 comprend une pluralité de bobines 11 auxquelles sont soudées les premières et deuxième barre de connexion électriques 12, 13, avec des bornes de connexion 14A, 14B. Aux extrémités des barres de connexion électriques 12, 13 se trouvent respectivement une borne de connexion électrique positive 120 et une borne de connexion électrique négative 130.

Le module de refroidissement 30 est visible en figure 5. Ledit module de refroidissement 30 est configuré pour dissiper la chaleur émise par la capacité de liaison 10. Le module de refroidissement 30 comprend une entrée 31 et une sortie 32 de fluide de refroidissement pour permettre l'entrée et la sortie d'un fluide caloporteur chargé de dissiper la chaleur émise par la capacité de liaison 10. Cette entrée 31 et cette sortie 32 de fluide de refroidissement forment des portions tubulaires s'étendant orthogonalement à la surface de base du module de refroidissement 30, en direction de la capacité de liaison 10, notamment de part et d'autre de cette dernière.

En référence à la figure 4, l'élément séparateur 20 disposé entre la capacité de liaison 10 et le module de refroidissement 30 assure un rôle essentiel. Ledit élément séparateur 20 forme un cadre principalement plan, avec une surface de base en forme de cadre rectangulaire, en particulier en plastique. Au centre de ce cadre est reçu un coussin de dissipation thermique 25 (« gap pad » en anglais) destiné à être comprimé au contact de la capacité de liaison 10 pour dissiper de la chaleur émise par cette dernière.

L'élément séparateur 20 est notamment en plastique rigide, par exemple en PBT GF30. Une fonction de cet élément séparateur 20 est de limiter la compression du coussin de dissipation thermique 25 de sorte à garantir que ladite compression reste inférieure à un seuil prédéfini, notamment de l'ordre de 30%. Ainsi, le coussin de dissipation thermique 25 conserve une épaisseur minimale souhaitée, lui permettant d'assurer efficacement une fonction de dissipation thermique, ladite épaisseur minimale du coussin de dissipation thermique 25 étant environ égale à l'épaisseur de l'élément séparateur 20. L'élément séparateur 20 permet aussi de maintenir une constance de l'épaisseur du coussin de dissipation thermique 25 et de ses propriétés thermiques dans le temps.

Selon le mode de réalisation représenté, l'élément séparateur 20 comporte en outre des parois de guidage 21, 22 correspondant à des parois concaves s'étendant orthogonalement à une surface de base de l'élément séparateur 20, en direction de la capacité de liaison 10, notamment de part et d'autre de ladite capacité de liaison 10, de façon à épouser sensiblement, à des fins de guidage, une partie de l'entrée 31 et de la sortie 32 de fluide de refroidissement, de forme tubulaire, appartenant au module de refroidissement 30.

Durant le montage de l'ensemble électrique 1, il est ainsi prévu que l'on empile, de bas en haut et dans cet ordre, l'élément séparateur 20, le coussin de dissipation thermique 25 qui se loge dans le cadre formé par ledit élément séparateur 20, puis la capacité de liaison 10. De préférence, l'élément séparateur 20 comprend des plots de centrage 23 issus de matière dudit élément séparateur 20 et permettant l'indexation, autrement dit le positionnement ou le centrage, de la capacité de liaison 10 sur ledit élément séparateur 20. En outre, l'élément séparateur 20 peut par exemple comprendre des bouterolles 200 formant des protubérances issues de sa masse et permettant de réaliser un rivetage pour assurer le maintien de la capacité de liaison 10 sur l'élément séparateur 20. Le bon positionnement de la capacité de liaison 10 facilite le vissage de l'ensemble électrique 1 dans le châssis pour former l'équipement électrique.

Plus précisément, en référence à la figure 4, l'élément séparateur 20 comprend, selon l'invention, un organe d'indexation 210. En particulier, selon une forme de réalisation, l'organe d'indexation 210 est issu de matière de l'élément séparateur 20. L'organe d'indexation 210 permet d'assurer un pré-centrage, avant vissage, de la capacité de liaison 10 vis-à-vis du module de puissance 40, lui-même représenté sur la figure 3. Grâce à l'organe d'indexation 210, on réduit le nombre d'éléments impliqués dans la chaîne de cotes permettant d'assurer le positionnement correct des bornes de connexion 14A, 14B de la capacité de liaison 10 par rapport aux bornes de connexion 41 du module de puissance 40. Autrement dit, on réduit le nombre d'élément de ladite « chaîne de cotes » et on améliore le positionnement précis et direct de la capacité de liaison 10 vis-à-vis du module de puissance 40 dans l'équipement électrique.

En effet, dans l'état de la technique, la chaîne de cotes implique : le module de puissance 40, qui présente une tolérance de montage vis-à-vis du module de refroidissement 30 ; le module de refroidissement 30 recevant l'élément séparateur 20 ; la capacité de liaison 10, qui est fixée sur l'élément séparateur 20. Cette chaîne de cotes implique au moins un élément de fonderie, à savoir le module de refroidissement 30, pour lequel la tolérance de fabrication relative aux cotes est élevée. Autrement dit, dans l'état de la technique, on n'obtient pas de centrage précis et direct de la capacité de liaison 10 sur l'élément séparateur 20 ni de l'élément séparateur 20 sur le module de puissance 40.

Grâce à l'invention, la chaîne de cotes implique les bornes de connexion 14A, 14B de la capacité de liaison 10 et celles 41 du module de puissance 40, l'organe d'indexation 210 assurant l'interface entre lesdites bornes de connexion 14A, 14B, 41 en réalisant une butée vis-à-vis desdites bornes de connexion 14A, 14B, 41, pour assurer le centrage de la capacité de liaison 10 vis-à-vis du module de puissance 40, ou plus précisément pour assurer le positionnement des bornes de connexion 14A, 14B de la capacité de liaison 10 par rapport aux bornes de connexion 41 du module de puissance 40.

Selon le mode de réalisation représenté, l'organe d'indexation 210 est en particulier formé de parois de centrage 211 issues de matière de l'élément séparateur 20, qui est notamment en plastique.

Les parois de centrage 211, que l'on peut désigner également, plus généralement, sous l'appellation de réseau de nervures, permettent de centrer directement les bornes de connexion 14A, 14B de la capacité de liaison 10 vis-à-vis des bornes de connexion 41 du module de puissance 40, sans nécessiter d'élément de centrage appartenant au module de refroidissement 30, qui est un élément de fonderie. Ainsi, l'organe d'indexation 210 s'indexe sur les bornes de connexion 14A, 14B de la capacité de liaison 10 et sur celles 41 du module de puissance 40.

L'organe d'indexation 210 présente ainsi notamment des parois de centrage 211 espacées formant deux à deux un passage pour recevoir une portion des bornes de connexion 41 du module de puissance 40 et, respectivement, des bornes de connexion 14A, 14B de la capacité de liaison 10. L'organe d'indexation 210 comprend alors de préférence, entre deux paires de parois de centrage 211, une poutre 212 orthogonale auxdites parois de centrage 211, pour les relier entre elles de façon à rigidifier l'organe d'indexation 210 et pour éviter que lesdites parois de centrage 211, qui guident les bornes de connexion respectives 14A, 14B, 41 de la capacité de liaison 10 et du module de puissance 40, ne se rapprochent l'une de l'autre. Autrement dit, les poutres 212 permettent d'éviter que les parois de centrage 211 constituant une paire de parois de centrage 211 formant un passage pour recevoir une borne de connexion respective 14A, 14B, 41 de la capacité de liaison 10 et du module de puissance 40 ne s'écartent l'une de l'autre en raison notamment d'une pression exercée par ladite borne de connexion respective 14A, 14B, 41 de la capacité de liaison 10 ou du module de puissance 40.

Ainsi, l'organe d'indexation 210 est notamment prévu sur l'élément séparateur 20 qui assure une fonction de limiteur de compression du coussin de dissipation thermique 25 ; il est précisé que, comme représenté sur la figure 4 et décrit ci-dessus, l'organe d'indexation 210 peut de préférence être issu de matière dudit élément séparateur 20. Toutefois, alternativement, l'organe d'indexation peut être une pièce rapportée dudit élément séparateur 20 et fixé sur celui-ci pour garantir la chaîne de cote courte.

Autrement dit, selon un mode de réalisation, l'organe d'indexation 210, qui fait partie de l'élément séparateur 20, présente une forme de « peigne » dont les dents s'indexent respectivement sur les bornes de connexion 41 du module de puissance 40 et sur celles 14A, 14B issues d'une barre de connexion électrique 12, 13 de la capacité de liaison 10.

De cette façon, on s'affranchit d'élément de centrage de la capacité 10 qui soit relatif à un élément de fonderie, comme le module de refroidissement 30 par exemple. Autrement dit, la chaîne de cotes relative au positionnement mutuel des bornes de connexion 14A, 14B de la capacité de liaison 10 et 41 du module de puissance 40 n'implique pas d'élément de fonderie. On assure le positionnement relatif correct des bornes de connexion 14A, 14B, 41 respectives de la capacité de liaison 10 et du module de puissance 40 directement par l'intermédiaire de l'organe d'indexation 210 qui fait partie de l'élément séparateur 20.

Compte-tenu de ce qui précède, la présente invention vise aussi un procédé d'assemblage d'un ensemble électrique 1 tel que décrit ci-dessus.

Selon ledit procédé d'assemblage, on dispose le module de refroidissement 30 sur lequel on dispose le module de puissance 40 ; puis on dispose sur le module de refroidissement 30 l'élément séparateur 20 comprenant l'organe d'indexation 210, de telle sorte que l'organe d'indexation 210 s'indexe sur les bornes de connexion 41 du module de puissance 40 ; puis on dispose la capacité de liaison 10 sur l'élément séparateur 20, de telle sorte que les bornes de connexion 14A, 14B de la capacité de liaison 10 s'indexent sur l'organe d'indexation 210 en étant guidé par ce dernier.

Il faut noter que l'élément séparateur 20 et la capacité de liaison 10 peuvent avoir été assemblés préalablement puis rapportés sur le module de refroidissement 30.

Les bornes de connexion 14A, 14B de la capacité de liaison 10 se trouvent de ce fait guidées au contact de l'organe d'indexation 210 de l'élément séparateur 20 de sorte que lesdites bornes de connexion 14A, 14B de la capacité de liaison 10 se trouvent directement positionnées de façon correspondante aux bornes de connexion 41 du module de puissance 40. La montabilité de l'ensemble électrique 1 est garantie et le vissage des bornes de connexion 14A, 14B, 41 respectives de la capacité de liaison 10 et du module de puissance 40 pour les fixer les unes aux autres peut être réalisé aisément.

Grâce à l'invention, on réalise notamment un ensemble électrique 1 pour un équipement électrique, notamment un onduleur, comprenant, assemblés de bas en haut, support 50, sur lequel on dispose le module de puissance 40, le module de refroidissement 30, recevant l'élément séparateur 20 comprenant l'organe d'indexation 210 et disposé entre le module de refroidissement 30 et la capacité de liaison 10, ladite capacité de liaison 10 comprenant au moins une barre de connexion électrique 12, 13 disposée du côté de l'élément séparateur 20.

Comme décrit précédemment, les bornes de connexion 14A, 14B de la capacité de liaison 10 et celles 41 du module de puissance 40 s'indexent respectivement sur l'organe d'indexation 210, lors du montage, de sorte à assurer le centrage de la capacité de liaison 10 directement vis-à-vis des bornes de connexion 41 du module de puissance 40.

D'autres caractéristiques de l'équipement électrique décrit ci-dessus sont détaillées ci-après. Notamment, le sous-ensemble constitué de l'élément séparateur 20, du coussin de dissipation thermique 25 et de la capacité de liaison 10 est disposé sur le module de refroidissement 30 fixé à un support 50 ou intégré à ce dernier. Comme expliqué ci-dessus, les parois de guidage 21, 22 coopèrent avec l'entrée 31 et la sortie 32 de fluide de refroidissement du module de refroidissement 30 pour permettre le guidage dudit sous-ensemble sur le module de refroidissement 30, fixé au support 50 ou intégré à ce dernier, formant le support 50 de l'ensemble électrique 1. Des seconds plots de centrage sont de préférence prévus, formant des plots issus de matière du module de refroidissement 30, pour assurer le positionnement de l'élément séparateur 20 sur ledit module de refroidissement 30. En outre, des bouterolles 200 en plastique, issues de matière de l'élément séparateur 20 et/ou des bouterolles en aluminium, issues de matière du module de refroidissement 30, peuvent être prévues pour assurer le maintien de l'élément séparateur 20 sur ledit module de refroidissement 30.

Une feuille d'isolation électrique est de préférence disposée entre l'élément séparateur 20 et le module de refroidissement 30. Ladite feuille d'isolation thermique permet d'augmenter le chemin de fuite pour d'éventuels courants de fuite se propageant via le coussin de dissipation thermique 25 ou l'élément séparateur 20. En outre, une extension de ladite feuille d'isolation électrique peut être prévue pour venir en vis-à-vis des bornes de connexion électrique positive 120 et négative 130 et ainsi isoler lesdites bornes de connexion électrique 120, 130 de la capacité de liaison 10 par rapport au module de refroidissement 30 et au support 50 et, plus généralement, par rapport au châssis de l'équipement électrique considéré.

L'équipement électrique est par exemple un onduleur pour un véhicule automobile électrique ou hybride.

## Revendications

1. Ensemble électrique (1) pour un équipement électrique, notamment un onduleur, comprenant :
- un support (50) comprenant un module de refroidissement (30) configuré pour dissiper de la chaleur émise par une capacité (10) ;
ladite capacité (10), configurée pour filtrer un signal électrique continu, comprenant au moins une bobine capacitive (11) et au moins une barre de connexion électrique (12, 13) fixée à ladite au moins une bobine capacitive (11), ladite au moins une barre de connexion électrique (12, 13) ayant des bornes de connexion (14A, 14B) ;
- un module de puissance (40) ayant des bornes de connexion (41) ;
- un élément séparateur (20) disposé entre la capacité de liaison (10) et le module de refroidissement (30), l'élément séparateur (20) comprend,
- un organe d'indexation (210) configuré pour s'indexer directement, respectivement, sur les bornes de connexion (14A, 14B) de la capacité (10) et les bornes de connexion (41) du module de puissance (40), de sorte à assurer le centrage des bornes de connexion (14A, 14B) de la capacité (10) directement vis-à-vis des bornes de connexion (41) du module de puissance (40) dans lequel l'organe d'indexation (210) est formé de parois de centrage (211) issues de matière de l'élément séparateur (20).

2. Ensemble électrique (1) selon la revendication 1, dans lequel l'élément séparateur(20) disposé entre le module de refroidissement (30) et la capacité (10) et adapté pour recevoir un coussin de dissipation thermique (25), ledit élément séparateur (20) étant configuré pour limiter le taux de compression du coussin de dissipation thermique (25) de sorte à garantir une épaisseur minimale prédéfinie dudit coussin de dissipation thermique (25).

3. Ensemble électrique (1) selon la revendication 2, dans lequel l'organe d'indexation (210) de l'élément séparateur (20) forme un peigne adapté pour s'indexer sur les bornes de connexion électrique (41) du module de puissance (40).

4. Ensemble électrique (1) selon l'une des revendications 2 à 3, dans lequel l'organe d'indexation (210) est un ensemble de nervures (213), en particulier formant lesdites parois de centrage (211).

5. Ensemble électrique (1) selon l'une des revendications précédentes, dans lequel l'organe d'indexation (210) comprend des parois de guidage (211) espacées formant un passage pour recevoir une portion des bornes de connexion (41) du module de puissance (40) et, respectivement, des bornes de connexion (14A, 14B) de la capacité (10).

6. Ensemble électrique (1) selon la revendication précédente, dans lequel l'organe d'indexation (210) comprend, entre chaque paire de parois de guidage (211), une poutre (212) orthogonale auxdites parois de guidage (211) pour les relier entre elles de façon à rigidifier l'organe d'indexation (210) et pour éviter que lesdites parois de guidage (211) ne se rapprochent l'une de l'autre.

7. Ensemble électrique (1) selon l'une des revendications précédentes, comportant un module de refroidissement (30), configuré pour être prise en sandwich entre ladite capacité (10) et ledit module de puissance (40).

8. Ensemble électrique (1) selon l'une des revendications précédentes, dans lequel la capacité (10) est une capacité de liaison configurée pour filtrer un signal électrique continu.

9. Procédé d'assemblage d'un ensemble électrique (1) selon l'une des revendications précédentes, dans lequel on dispose le module de refroidissement (30), puis on dispose le module de puissance (40), puis on dispose l'élément séparateur (20) comprenant l'organe d'indexation (210) sur le module de refroidissement (30), de telle sorte que l'organe d'indexation (210) s'indexe sur les bornes de connexion (41) du module de puissance (40), puis on dispose la capacité (10) sur l'élément séparateur (20), de telle sorte que les bornes de connexion (14A, 14B) de la capacité (10) s'indexent sur l'organe d'indexation (210) en étant guidées par ce dernier.

10. Equipement électrique, notamment un onduleur, comprenant un châssis, formant un boîtier avec un fond et des parois latérales, et un ensemble électrique (1) selon l'une des revendications 1 à 8, ledit ensemble électrique (1) étant inséré à l'intérieur dudit châssis.

11. Equipement électrique selon la revendication précédente, dans lequel ledit ensemble électrique (1) est fixé à un élément solidaire dudit châssis.

12. Equipement électrique selon la revendication 10 ou 11, dans lequel ledit support (50) est un couvercle de l'équipement électrique.

13. Equipement électrique selon l'une des revendications 10 à 12, formant un onduleur électrique, pour un véhicule automobile.

## Patentansprüche

1. Elektrische Baugruppe (1) für ein elektrisches Gerät, insbesondere einen Wechselrichter, mit
- einem Träger (50), der ein Kühlmodul (30) umfasst, das so konfiguriert ist, dass es von einer Kapazität (10) abgegebene Wärme abführt;
wobei die Kapazität (10), die so konfiguriert ist, dass sie ein elektrisches Gleichstromsignal filtert, mindestens eine kapazitive Spule (11) und mindestens eine elektrische Verbindungsschiene (12, 13) umfasst, die an der mindestens einen kapazitiven Spule (11) befestigt ist, wobei die mindestens eine elektrische Verbindungsschiene (12, 13) Verbindungsanschlüsse (i 4A, 14B) aufweist;
- ein Leistungsmodul (40), das Verbindungsanschlüsse (41) aufweist;
- ein Trennelement (20), das zwischen der Verbindungskapazität (10) und dem Kühlmodul (30) angeordnet ist, wobei das Trennelement (20) Folgendes umfasst,
- ein Indexierungsglied (210), das so konfiguriert ist, dass es direkt auf die Verbindungsanschlüsse (14A, 14B) der Kapazität (10) bzw. die Verbindungsanschlüsse (41) des Leistungsmoduls (40) indexiert werden kann, um so die Zentrierung der Verbindungsanschlüsse (14A, 14B) der Kapazität (10) direkt gegenüber den Verbindungsanschlüssen (41) des Leistungsmoduls (40), wobei das Indexierungsglied (210) mit Zentrierwänden (211) aus dem Material des Trennelements (20) ausgebildet ist.

2. Elektrische Baugruppe (1) nach Anspruch 1, wobei das Trennelement (20) zwischen dem Kühlmodul (30) und der Kapazität (10) angeordnet ist und zur Aufnahme eines Wärmeableitungskissens (25) geeignet ist, wobei das Trennelement (20) so konfiguriert ist, dass es die Kompressionsrate des Wärmeableitungskissens (25) begrenzt, um eine vordefinierte Mindestdicke des Wärmeableitungskissens (25) zu gewährleisten.

3. Elektrische Baugruppe (1) nach Anspruch 2, wobei das Indexierungsorgan (210) des Trennelements (20) einen Kamm bildet, der so angepasst ist, dass er sich mit den elektrischen Verbindungsanschlüssen (41) des Leistungsmoduls (40) indexieren lässt.

4. Elektrische Baugruppe (1) nach einem der Ansprüche 2 bis 3, wobei das Indexierungsorgan (210) eine Anordnung von Rippen (213) ist, die insbesondere die Zentrierwände (2i 1) bilden.

5. Elektrische Baugruppe (1) nach einem der vorhergehenden Ansprüche, wobei das Indexierungsglied (210) beabstandete Führungswände (211) umfasst, die einen Durchgang zur Aufnahme eines Teils der Verbindungsanschlüsse (41) des Leistungsmoduls (40) und jeweils der Verbindungsanschlüsse (14A, 14B) der Kapazität (10) bilden.

6. Elektrische Baugruppe (1) nach dem vorhergehenden Anspruch, bei der das Indexierungsorgan (210) zwischen jedem Paar von Führungswänden (211) einen zu den Führungswänden (211) orthogonalen Träger (212) umfasst, um sie miteinander zu verbinden, um das Indexierungsorgan (210) zu versteifen und um zu verhindern, dass sich die Führungswände (211) einander annähern.

7. Elektrische Baugruppe (1) nach einem der vorhergehenden Ansprüche, mit einem Kühlmodul (30), das so gestaltet ist, dass es zwischen der Kapazität (10) und dem Leistungsmodul (40) eingeklemmt ist.

8. Elektrische Baugruppe (1) nach einem der vorhergehenden Ansprüche, wobei die Kapazität (10) eine Link-Kapazität ist, die so konfiguriert ist, dass sie ein elektrisches Gleichstromsignal filtert.

9. Verfahren zum Zusammenbau einer elektrischen Baugruppe (1) nach einem der vorhergehenden Ansprüche, bei dem das Kühlmodul (30) angeordnet wird, dann das Leistungsmodul (40) angeordnet wird, dann das Trennelement (20), das das Indexierungsorgan (210) umfasst, auf dem Kühlmodul (30) angeordnet wird, so dass das Indexierungsorgan (210) auf die Verbindungsanschlüsse (4i) des Leistungsmoduls (40) indexiert, dann die Kapazität (10) auf dem Trennelement (20) angeordnet wird, so dass die Verbindungsanschlüsse (14A, 148) der Kapazität (10) auf das Indexierungsorgan (210) indexiert werden, indem sie von diesem geführt werden.

10. Elektrische Ausrüstung, insbesondere ein Wechselrichter, mit einem Chassis, das ein Gehäuse mit einem Boden und Seitenwänden bildet, und einer elektrischen Baugruppe (1) nach einem der Ansprüche 1 bis 8, wobei die elektrische Baugruppe (1) in das Innere des Chassis eingefügt ist.

11. Elektrische Ausrüstung nach dem vorhergehenden Anspruch, wobei die elektrische Baugruppe (1) an einem integralen Element des Chassis befestigt ist.

12. Elektrische Ausrüstung nach Anspruch 10 oder i 1, wobei die Halterung (50) eine Abdeckung der elektrischen Ausrüstung ist.

13. Elektrische Ausrüstung nach einem der Ansprüche 10 bis 12, die einen elektrischen Wechselrichter bildet, für ein Kraftfahrzeug.

## Claims

1. An electrical assembly (1) for electrical equipment, in particular an inverter, comprising:
- a support (50) comprising a cooling module (30) configured to dissipate heat emitted by a capacitor (10);
said capacitor (10), configured to filter a DC electrical signal, comprising at least one capacitive coil (11) and at least one electrical connection bar (12, 13) attached to said at least one capacitive coil (11), said at least one electrical connection bar (12, 13) having connection terminals (14A, 14B)
- a power module (40) having connection terminals (41);
- a separator element (20) disposed between the connection capacity (10) and the cooling module (30), the separator element (20) comprises,
- an indexing member (210) configured to index directly, respectively, to the connection terminals (14A, 14B) of the capacitor (10) and the connection terminals (41) of the power module (40), so as to ensure centering of the connection terminals (14A, (14A, 14B) of the capacitor (10) and the connection terminals (41) of the power module (40), so as to ensure centring of the connection terminals (14A, 14B) of the capacitor (10) directly with respect to the connection terminals (41) of the power module (40), wherein the indexing member (210) is formed by centring walls (211) made of the material of the separator element (20).

2. The electrical assembly (1) according to claim 1, wherein the separator element (20) is disposed between the cooling module (30) and the capacitor (10) and adapted to receive a heat sink pad (25), said separator element (20) being configured to limit the compression ratio of the heat sink pad (25) so as to ensure a predefined minimum thickness of said heat sink pad (25).

3. The electrical assembly (1) according to claim 2, wherein the indexing member (210) of the separator element (20) forms a comb adapted to index on the electrical connection terminals (41) of the power module (40).

4. The electrical assembly (1) according to any of claims 2 to 3, wherein the indexing member (210) is a set of ribs (213), in particular forming said centering walls (2i 1).

5. The electrical assembly (1) according to any of the preceding claims, wherein the indexing member (210) comprises spaced guide walls (211) forming a passage for receiving a portion of the connection terminals (41) of the power module (40) and, respectively, the connection terminals (14A, 14B) of the capacitor (10).

6. The electrical assembly (1) according to the preceding claim, wherein the indexing member (210) comprises, between each pair of guide walls (211), a beam (212) orthogonal to said guide walls (211) to connect them together so as to stiffen the indexing member (210) and to prevent said guide walls (211) from coming closer to each other.

7. An electrical assembly (1) according to any of the preceding claims, comprising a cooling module (30), configured to be sandwiched between said capacitor (10) and said power module (40).

8. An electrical assembly (1) according to any of the preceding claims, wherein the capacitor (10) is a link capacitor configured to filter a DC electrical signal.

9. A method of assembling an electrical assembly (1) according to any of the preceding claims, wherein the cooling module (30) is arranged, then the power module (40) is arranged therefrom, then the separator element (20) comprising the indexing member (210) is arranged on the cooling module (30), such that the indexing member (210) indexes to the connection terminals (4i) of the power module (40), and then arranges the capacitor (10) on the separator element (20), such that the connection terminals (14A, 148) of the capacitor (10) index to the indexing member (210) by being guided by the latter

10. Electrical equipment, in particular an inverter, comprising a frame, forming a housing with a bottom and side walls, and an electrical assembly (1) according to one of claims 1 to 8, said electrical assembly (1) being inserted inside said frame.

11. Electrical equipment according to the preceding claim, wherein said electrical assembly (1) is fixed to a member integral with said frame.

12. Electrical equipment according to claim 10 or i 1, wherein said support (50) is a cover of the electrical equipment.

13. Electrical equipment according to any of claims 10 to 12, forming an electrical inverter, for a motor vehicle.
